# EUROPEAN PATENT APPLICATION

(11) **EP 2 337 073 A1**
(43) Date of publication of application: **22.06.2011**
(21) Application number: 10195965.8
(22) Date of filing: 20.12.2010
(51) Int. Cl.: H01L 25/075, H01L 27/15, G09F 9/33, F21K 99/00, H01L 33/48, H01L 33/64

(54) **Light transmissible display apparatus**

(30) Priority: 21.12.2009 TW 098143959
(71) Applicant: Aussmak Optoelectronic Corp., Yongkang City, Tainan County 710 (TW)
(72) Inventor: Lin, Chung-Jyh, YongKang City, Tainan County 710 (TW)
(74) Representative: 2K Patentanwälte Blasberg Kewitz & Reichel

(57) **Abstract**

A light transmissible display apparatus (1) includes a first light transmissible substrate (11) and at least one light-emitting diode (LED) light bar (12) disposed on the first light transmissible substrate (11). The light transmissible display apparatus (1) makes people who live or work inside a building enjoy natural light from outside, and further saves the labor hour in processes of manufacturing the display apparatus.

## Description

### BACKGROUND OF THE INVENTION

### FIELD OF INVENTION

The invention relates to a display apparatus and, in particular, to a light transmissible display apparatus.

### RELATED ART

Recently, the material and the manufacturing process of a light-emitting diode (LED) have been continuously improved such that the light-emitting efficiency of the LED is significantly enhanced. Different from the typical fluorescent lamp or energy-saving light bulb, the LED has the properties of the low power consumption, the long lifetime, the high security, the short response time of emitting light and the small size, and has been gradually applied to the illuminating apparatus or display apparatus.

In an example where a display apparatus made of LEDs may be applied to a display billboard, the prior art is to dispose a plurality of LEDs on a substrate, and to control the light-emitting intensities or the colors of output light beams of the LEDs to form a text or a pattern to display information. However, this kind of display apparatus is usually mounted on the outer wall, the window or the glass curtain of the building, and may thus obstruct the light beams from the outside so that the people who live or work in the building cannot enjoy the natural light.

In addition, each LED has the very small size. It is very time-consumptive and labor-consumptive to dispose many LEDs individually on the substrate.

Therefore, it is an important subject to provide a light transmissible display apparatus, which makes people who live or work inside a building enjoy natural light from outside, and further saves the labor hour in processes of manufacturing the display apparatus.

### SUMMARY OF THE INVENTION

In view of the foregoing subject, an objective of the invention is to provide a light transmissible display apparatus, which makes people who live or work inside a building enjoy natural light from outside, and further saves the labor hour in processes of manufacturing the display apparatus.

To achieve the above objective, the present invention discloses a light transmissible display apparatus including a first light transmissible substrate and at least one light-emitting diode (LED) light bar. The LED light bar is disposed on the first light transmissible substrate.

In one embodiment of the invention, the LED light bar has a plurality of packaged LED elements disposed on a circuit board by way of surface mount technology (SMT) or dual in-line package (DIP).

In one embodiment of the invention, the LED light bar has a plurality of LED dies and a circuit board, and the LED dies are disposed on the circuit board by way of wire bonding or flip chip bonding.

In one embodiment of the invention, the first light transmissible substrate has a plurality of positioning portions aligned with the LED light bar.

In one embodiment of the invention, the light transmissible display apparatus further includes a molding compound covering the LED light bar.

In one embodiment of the invention, the light transmissible display apparatus further includes a second light transmissible substrate disposed opposite the first light transmissible substrate. The LED light bar is interposed between the first light transmissible substrate and the second light transmissible substrate.

In one embodiment of the invention, the second light transmissible substrate has a plurality of positioning portions, and the LED light bar has a plurality of LEDs, which are aligned with the positioning portions respectively.

In one embodiment of the invention, the light transmissible display apparatus further includes an adhesive layer disposed between the first light transmissible substrate and the second light transmissible substrate.

In one embodiment of the invention, the light transmissible display apparatus further includes at least one thermoconductive element disposed corresponding to the LED light bar.

As mentioned above, the light transmissible display apparatus according to the invention has the LED elements disposed on the first light transmissible substrate in the form of light bars. When the light transmissible display apparatus is disposed on the outer wall of the building to serve as the display billboard, the natural light coming from the outside can enter the building through the gap between two LED light bars. Thus, the people who live or work in the building still can enjoy the natural light from the outside. In addition, disposing the LED elements on the first light transmissible substrate in the form of light bars can save the labor hour as compared with the processes of individually disposing the LED elements on the substrate. In addition, the LED light bars according to the embodiment of the invention may be aligned with the positioning portions to save the labor hour of the manufacturing processes when either the first or second light transmissible substrate has the positioning portions. In addition, the positioning portion is configured such that the LED elements can be orderly disposed on the first light transmissible substrate without being precisely aligned. So, the quality of the product can be significantly enhanced.

### BRIEF DESCRIPTION OF THE DRAWINGS

The invention will become more fully understood from the detailed description and accompanying drawings, which are given for illustration only, and thus are not limitative of the present invention, and wherein:

FIGS. 1A and 1B are respectively a pictorial view showing a light transmissible display apparatus and a cross-sectional view taken along a straight line A-A of FIG. 1 A according to a preferred embodiment of the invention;

FIG. 2A is a cross-sectional view showing a light transmissible display apparatus of another aspect according to the preferred embodiment of the invention;

FIG. 2B is a cross-sectional view of the light transmissible display apparatus taken along a vertical straight line A-A of FIG. 2A;

FIG. 2C is a cross-sectional view showing still another aspect of the light transmissible display apparatus according to the preferred embodiment of the invention;

FIG. 2D is a cross-sectional view showing yet still another aspect of the light transmissible display apparatus according to the preferred embodiment of the invention;

FIG. 2E is a cross-sectional view of the light transmissible display apparatus taken along a vertical straight line A-A of FIG. 2D;

FIGS. 3A and 3B are respectively a pictorial view showing yet still another aspect of the light transmissible display apparatus and a cross-sectional view taken along a straight line B-B of FIG. 3A according to the preferred embodiment of the invention;

FIGS. 4A to 4C are cross-sectional views showing yet still another aspect of the light transmissible display apparatus according to the preferred embodiment of the invention;

FIGS. 5A to 5C are cross-sectional views showing yet still another aspect of the light transmissible display apparatus according to the preferred embodiment of the invention; and

FIGS. 6A to 6C are respectively cross-sectional views of the light transmissible display apparatuses corresponding to FIGS. 5A to 5C and taken along the straight line A-A.

### DETAILED DESCRIPTION OF THE INVENTION

The present invention will be apparent from the following detailed description, which proceeds with reference to the accompanying drawings, wherein the same references relate to the same elements.

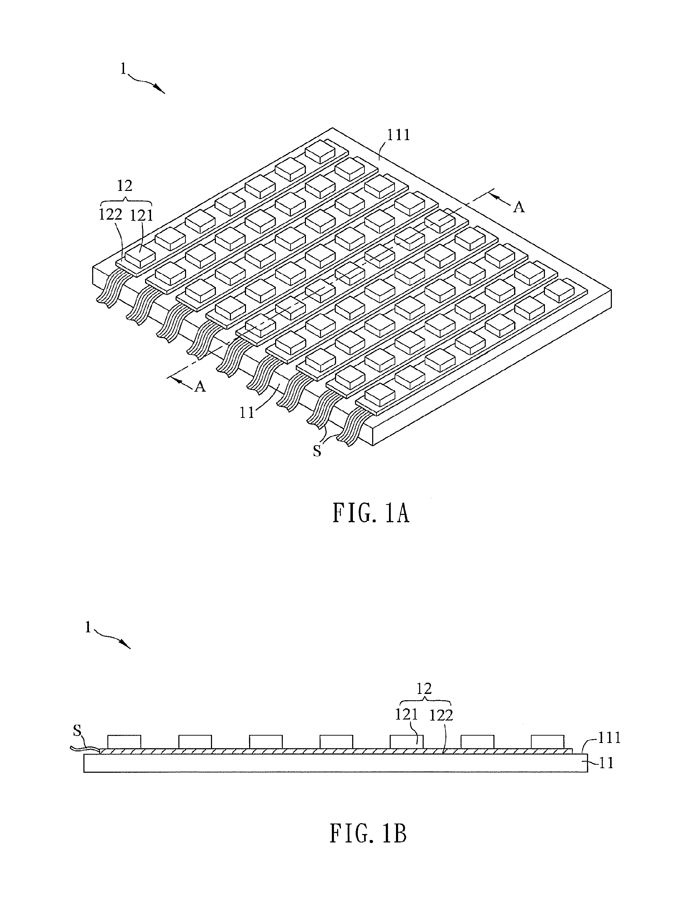

FIGS. 1A and 1B are respectively a pictorial view showing a light transmissible display apparatus 1 and a cross-sectional view taken along a straight line A-A of FIG. 1A according to a preferred embodiment of the invention. As shown in FIGS. 1A and 1B, the light transmissible display apparatus 1 of the invention may be applied to, for example but without limitation to, a display billboard. The light transmissible display apparatus 1 may be disposed on an outer wall, a window or a glass curtain of the building, may also be disposed on the indoor partition wall, and can display information by controlling the intensity or color of the light outputted by the light transmissible display apparatus 1.

The light transmissible display apparatus 1 includes a first light transmissible substrate 11 and at least one LED light bar 12. In this example embodiment, the light transmissible display apparatus 1 has a plurality of LED light bars 12, and the LED light bars 12 are arranged in a one-dimensional or two-dimensional array, and disposed on a surface 111 of the first light transmissible substrate 11, wherein a gap is formed between neighboring two of the LED light bars 12.

The material of the first light transmissible substrate 11 may be, without limitation to, the glass, sapphire, quartz or plastic material. Herein, the first light transmissible substrate 11 is made of the glass material.

The LED light bar 12 is disposed on the first light transmissible substrate 11. The LED light bar 12 may have, for example, a plurality of packaged LED elements 121 disposed on a circuit board 122 by way of surface mount technology (SMT) or dual in-line package (DIP). Alternatively, the LED light bar 12 may have, for example, a plurality of LED dies disposed on the circuit board 122 by way of wire bonding or flip chip bonding. The material of the circuit board 122 may be, for example, the resin, metal core, glass, ceramics or a combination thereof.

The LED light bar 12 of this example embodiment has the packaged LED elements 121 disposed on the circuit board 122, and the circuit board 122 is an opaque flexible circuit board. Of course, the circuit board 122 may be the typical printed circuit board. In addition, the circuit board 122 may be electrically connected to a control circuit (not shown) through a cable S. The control circuit can control the intensity or color of the light outputted by each LED element 121 of the LED light bar 12 to form a text or a pattern and thus to display the information. It is to be explained that the circuit board 122 of the LED light bar 12 of this embodiment is opaque, so the light transmissible display apparatus 1 is a top lighting display apparatus.

Each LED light bar 12 disposed on the first light transmissible substrate 11 has many LED elements 121. So, when the LED elements are disposed on the first light transmissible substrate 11 in the form of a light bar, it is unnecessary to individually dispose the LED elements 121 on the first light transmissible substrate 11. In addition, no circuit layer has to be formed on the first light transmissible substrate 11. Thus, the labor hour for the manufacturing processes may be decreased.

In addition to the horizontal placement aspect of FIG. 1 of the light transmissible display apparatus 1 of the invention, the light transmissible display apparatus 1 may also be disposed in an upright manner and may be hung from the outer wall, the window or the glass curtain in a building, and disposed on the indoor partition wall.

The opaque circuit board 122 can obstruct the light, outputted from the bottom of the LED element 121, from passing through the first light transmissible substrate 11 and entering indoors (see the bottom of the substrate 11 of FIG. 1A), and the gaps between the circuit boards 122 still can make the people who live or work in the building enjoy natural light incident from the outside to the inside (see the top of the substrate 11 of FIG. 1A).

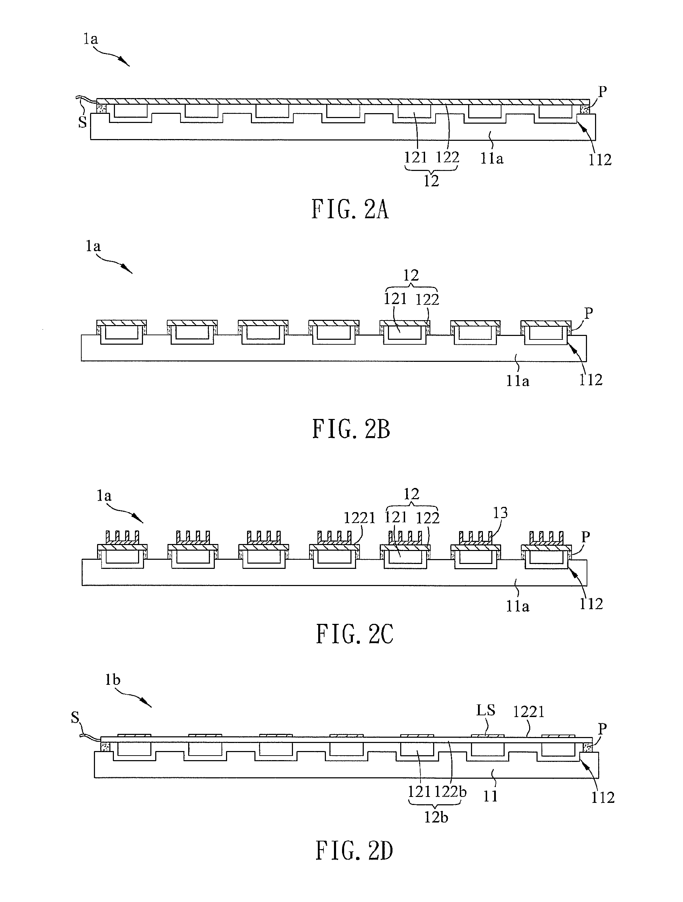

FIG. 2A is a cross-sectional view showing a light transmissible display apparatus 1a of another aspect according to the preferred embodiment of the invention, and FIG. 2B is a cross-sectional view of the light transmissible display apparatus 1a taken along a vertical straight line A-A of FIG. 2A.

As shown in FIGS. 2A and 2B, a first light transmissible substrate 11a may further have a plurality of positioning portions 112 respectively aligned with the LED light bars 12. Herein, a plurality of concave or convex positioning portions 112 may be disposed on the first light transmissible substrate 11a by way of, for example, molding, adhering or printing, such that the LED elements 121 of the LED light bars 12 may be respectively aligned with the positioning portions 112. In this embodiment, the first light transmissible substrate 11a is formed with the concave positioning portions 112, and each of the LED elements 121 is aligned with one positioning portion 112 in this illustrated embodiment. Of course, each LED light bar 12 may also be aligned with one positioning portion 112, and the invention is not particularly restricted thereto.

In addition, in order to further protect the LED elements 121, a sealant P may be applied to a connection periphery between the LED light bar 12 and the first light transmissible substrate 11a to seal both of them. The sealant P can adhere the LED light bar 12 to the first light transmissible substrate 11a, and further prevent the moisture or foreign object from entering the space between the LED light bar 12 and the first light transmissible substrate 11a to affect the light-emitting efficiency of the LED elements 121. The material of the sealant P may include, for example, a silicon sealant, an epoxy sealant, an acrylic sealant, or the like. It is to be noted that, if the height of the sealant P is greater than or equal to that of the LED element 121, the first light transmissible substrate 11 a needs not to have the positioning portion 112, and may be a light transmissible flat panel, so that the LED light bars 12 and the first light transmissible substrate 11a may be directly adhered together.

Thus, the positioning portions 112 formed on the first light transmissible substrate 11 a can help the LED light bar 12 be aligned with the positioning portion 112, so that the LED light bars 12 may be disposed on the first light transmissible substrate 11a more rapidly, and the labor hour for the manufacturing processes may be further saved. In addition, the LED elements 121 need not to be precisely arranged in an aligned manner and may be orderly disposed on the first light transmissible substrate 11 a according to the configuration of the positioning portion 112. So, the quality of the product can be significantly enhanced. It is to be noted that a light transmissible display apparatus 1a, formed by directly adhering the LED light bar 12 and the first light transmissible substrate 11a together, has the downward lighting direction, which means that the light, emitted from the LED light bar 12 or the LED element 121, downwardly transmits the first light transmissible substrate 11a and emits out. Thus, the first light transmissible substrate 11a has a light output surface, disposed on one side opposite the LED elements 121.

As shown in FIG. 2C, the light transmissible display apparatus 1a may further include at least one thermoconductive element 13 corresponding to the LED light bar 12 or thermoconductive elements 13 respectively corresponding to the LED light bars 12. In this embodiment, the light transmissible display apparatus 1a has a plurality of thermoconductive elements 13 respectively disposed on surfaces 1221 of the circuit boards 122 of the LED light bars 12, and corresponding to the LED light bars 12. The thermoconductive element 13, having the better coefficient of heat conductivity, can dissipate the heat generated by the LED light bar 12 to decrease the heat of the light transmissible display apparatus 1a and increase the reliability of the product. In this embodiment, the thermoconductive element 13 includes a plurality of longitudinal heat dissipating fins, arranged in parallel and disposed on the surface 1221 of the circuit board 122 of the LED light bar 12, and the thermoconductive elements 13 respectively correspond to the LED light bars 12. The material of the thermoconductive element 13 may include, for example, metal or an alloy, and preferably include aluminum to dissipate the heat of the LED light bar 12 more rapidly, and thus to increase the reliability of the light transmissible display apparatus 1a.

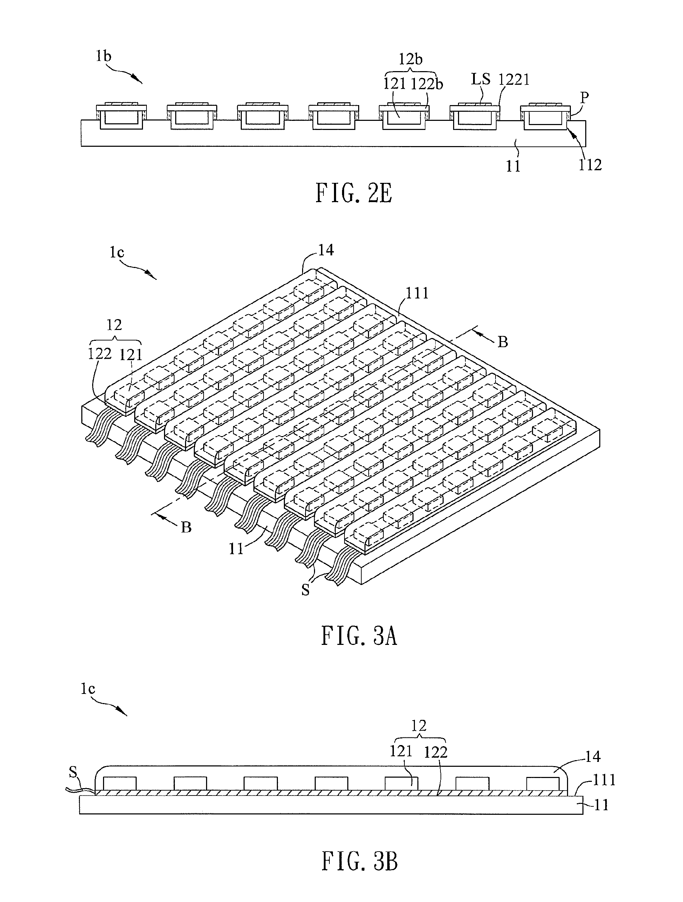

FIG. 2D is a cross-sectional view showing yet still another aspect of the light transmissible display apparatus 1b according to the preferred embodiment of the invention, and FIG. 2E is a cross-sectional view of the light transmissible display apparatus 1b taken along a vertical straight line A-A of FIG. 2D.

As shown in FIGS. 2D and 2E, if the circuit board 122b (e.g., a glass circuit board) of the LED light bar 12 is made of a light transmissible material, it is also possible to dispose a light-obstructing layer LS on a backside (surface 1221) of the LED light bar 12b at a position corresponding to the LED element 121 in order to prevent the light, outputted from the bottom surface of the LED element 121, from affecting the user, such that a light transmissible display apparatus 1b becomes a bottom lighting display apparatus. It is to be specified that the overall transmission of the light transmissible display apparatus 1b can be enhanced because the circuit board 122b of the LED light bar 12 of this aspect may be made of a light transmissible material (e.g., glass).

FIGS. 3A and 3B are respectively a pictorial view showing yet still another aspect of the light transmissible display apparatus 1c and a cross-sectional view taken along a straight line B-B of FIG. 3A according to the preferred embodiment of the invention. As shown in FIGS. 3A and 3B, the main difference between the light transmissible display apparatus 1c of this aspect and the light transmissible display apparatus 1 of FIG. 1A resides in that the light transmissible display apparatus 1c further includes an molding compound 14 covering the LED light bar 12. In this example embodiment, multiple molding compounds 14 respectively cover multiple LED light bars 12, but the invention is not particularly restricted thereto. Of course, it is also possible to utilize a single molding compound to cover all the LED light bars 12 on the first light transmissible substrate 11. The material of the molding compound 14 may include, for example, the silica gel, epoxy resin sealant or acrylic sealant, to protect the LED light bar 12 from being invaded by the moisture or foreign objects, which can affect the light-emitting efficiency and the lifetime of the LED light bar 12.

It is to be specified that the light transmissible display apparatus 1c is a top lighting display apparatus if the circuit board 122 is made of the opaque material but the molding compound 14 is made of the light transmissible material, and that the light transmissible display apparatus 1c is a bottom lighting display apparatus if the circuit board 122 is made of the light transmissible material but the molding compound 14 is made of the opaque material.

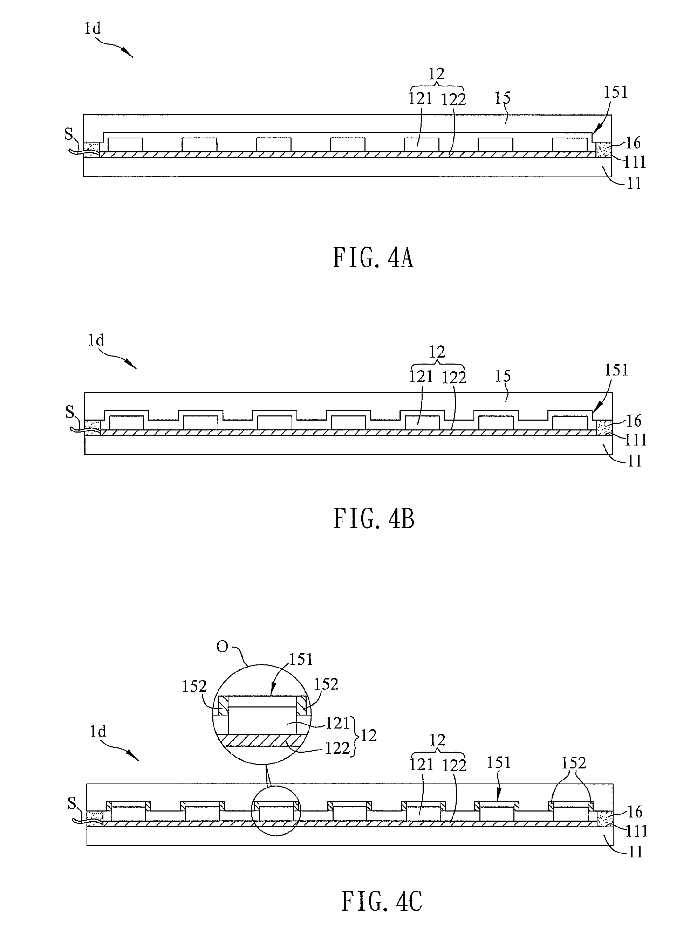

FIGS. 4A and 4B are cross-sectional views showing yet still another aspect of the light transmissible display apparatus 1d according to the preferred embodiment of the invention. As shown in FIGS. 4A and 4B, the main difference between the light transmissible display apparatus 1d of this aspect and the light transmissible display apparatus 1 of FIG. 1A resides in that the light transmissible display apparatus 1d may further include a second light transmissible substrate 15 disposed opposite the first light transmissible substrate 11, and that the LED light bar 12 is interposed between the first light transmissible substrate 11 and the second light transmissible substrate 15. The first light transmissible substrate 11 and the second light transmissible substrate 15 may be light transmissible glass substrates.

In this embodiment, the second light transmissible substrate 15 may have, for example, a plurality of positioning portions 151 and each LED light bar 12 may be aligned with one of the positioning portions 151. Of course, each LED light bar 12 may correspond to a plurality of positioning portions 151, as shown in FIG. 4B. That is, each LED element 121 of the LED light bar 12 is aligned with one of the positioning portions 151. Herein, the invention is not particularly restricted.

Herein, a plurality of concave or convex positioning portions 151 may be disposed on the first light transmissible substrate 11 by way of, for example, molding, adhering, printing and the like, such that the LED elements 121 of the LED light bar 12 may be respectively aligned with the positioning portions 151. In this example embodiment, multiple concave positioning portions 151 are formed on the second light transmissible substrate 15. In the example of FIG. 4A, one LED light bar 12 is aligned with one positioning portion 151. In the example of FIG. 4B, one LED element 121 is aligned with one positioning portion 151.

The LED light bar 12 or the LED elements 121 may be aligned with the second light transmissible substrate 15 more rapidly according to the positioning portions 151 of the second light transmissible substrate 15, and then may be disposed on the first light transmissible substrate 11 to finish the processes of assembling the light transmissible display apparatus 1d rapidly. Thus, the labor hour for the processes of manufacturing the light transmissible display apparatus 1d may be saved.

As shown in FIG. 4C, a light-obstructing layer 152 may be disposed on a periphery of each positioning portion 151 of the second light transmissible substrate 15. The light-obstructing layers 152 make the light beams, emitted from the LED elements 121, travel in the same specific direction (the upward direction in this embodiment) without interfering with one another. The light-obstructing layer 152 may be disposed on the periphery of the positioning portion 151 by way of, for example, sputtering, printing, coating, or adhering. The region O of FIG. 4C is the partially enlarged view of the portion near the positioning portion 151 and the light-obstructing layer 152.

Herein, it is to be specified that the processes of assembling the display apparatus can be finished by firstly disposing the molding compound 14 of FIG. 3 to cover each LED light bar 12, and then disposing the positioning portion 151 of the second light transmissible substrate 15 in alignment with each molding compound 14. Of course, the positioning portions 151 of the second light transmissible substrate 15 may be respectively directly aligned with the LED light bars 12 or the LED elements 121 in the manners similar to those of FIGS. 4A to 4C.

In addition, as shown in FIGS. 4A to 4C, the light transmissible display apparatus 1d may further include an adhesive layer 16, disposed between the first light transmissible substrate 11 and the second light transmissible substrate 15, for directly adhering the first light transmissible substrate 11 to the second light transmissible substrate 15 and/or the periphery connected thereto to completely seal the first light transmissible substrate 11 and the second light transmissible substrate 15 and thus to protect the light transmissible display apparatus 1d more completely. In this embodiment, the adhesive layer 16 is disposed on the connection periphery between the first light transmissible substrate 11 and the second light transmissible substrate 15. In addition to adhering the first light transmissible substrate 11 and the second light transmissible substrate 15 together, the adhesive layer 16 may also prevent the moisture or foreign objects from entering the space between the substrates 11 and 15 to affect the light-emitting efficiency of the LED element 121. The material of the adhesive layer 16 may include, for example, the silica gel, the epoxy resin sealant or the acrylic sealant.

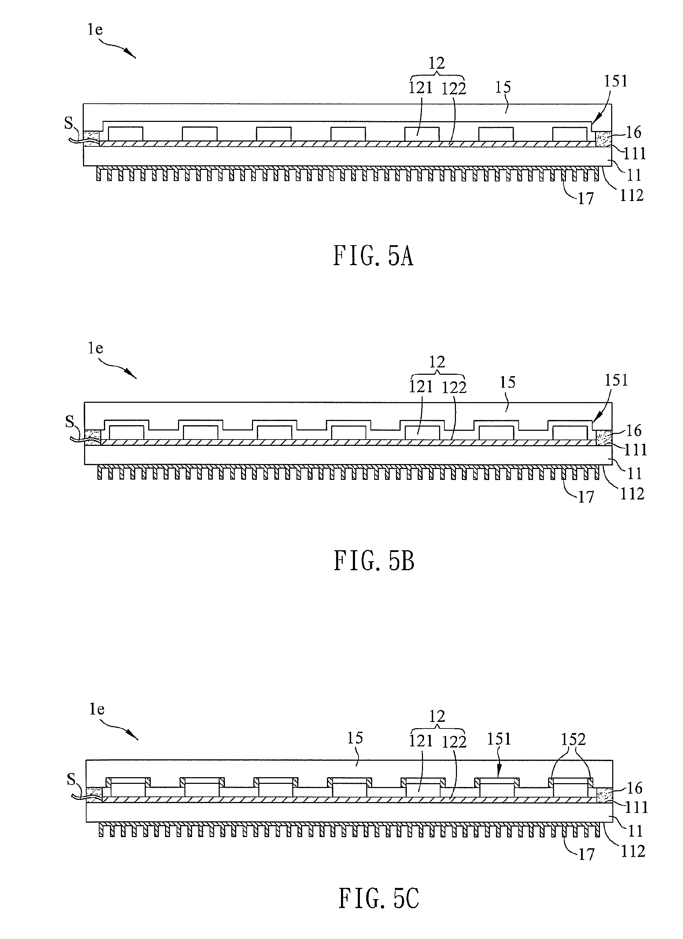

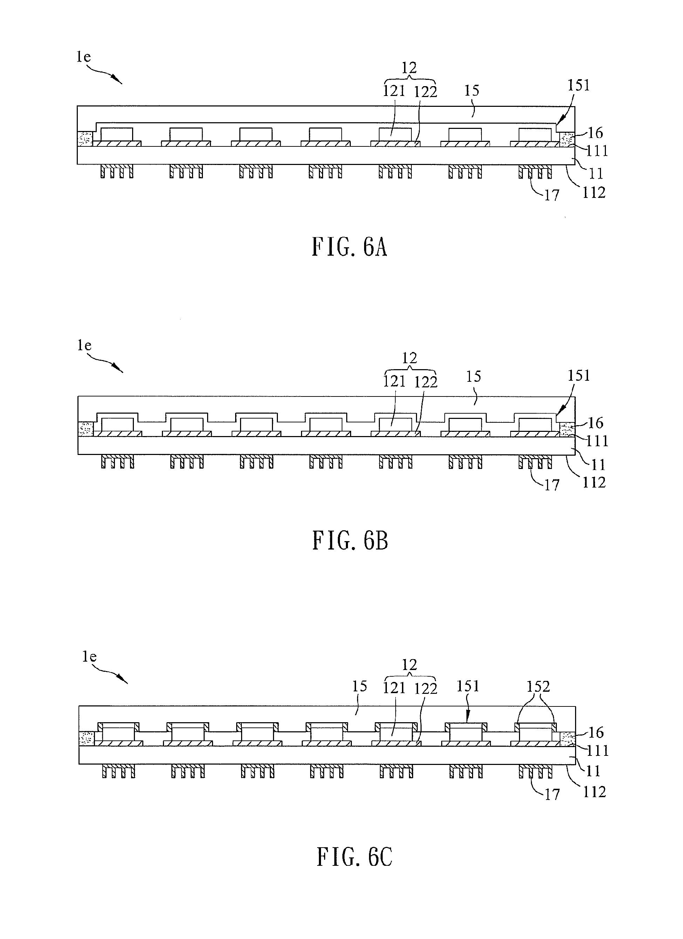

FIGS. 5A to 5C are cross-sectional views showing yet still another aspect of a light transmissible display apparatus 1e according to the preferred embodiment of the invention, and FIGS. 6A to 6C are respectively cross-sectional views of the light transmissible display apparatuses 1e corresponding to FIGS. 5A to 5C and taken along the straight line A-A.

Referring to FIGS. 5A to 5C and 6A to 6C, the light transmissible display apparatus 1e may further include at least one thermoconductive element 17, which is disposed on the first light transmissible substrate 11 and corresponds to the LED light bar 12. In this embodiment, the light transmissible display apparatus 1e has multiple thermoconductive elements 17, which are respectively disposed on the other surface 112 of the first light transmissible substrate 11 opposite to the surface 111 and respectively correspond to the LED light bars 12. The thermoconductive element 17 can dissipate the heat, transferred from the LED light bar 12 to the first light transmissible substrate 11, to decrease the heat of the light transmissible display apparatus 1e and increase the reliability of the product.

In this embodiment, the thermoconductive elements 17 may be multiple longitudinal heat dissipating fins, which are arranged in parallel and disposed on the surface 112 of the light transmissible substrate 11 and respectively correspond to the LED light bars 12. The material of the thermoconductive element 17 may include, for example, the metal or alloy, and is preferably the aluminum to dissipate the heat of the LED light bar 12 more rapidly and enhance the reliability of the light transmissible display apparatus 1e.

To sum up, the light transmissible display apparatus according to the invention has the LED elements disposed on the first light transmissible substrate in the form of light bars. When the light transmissible display apparatus is disposed on the outer wall of the building to serve as the display billboard, the natural light coming from the outside can enter the building through the gap between two LED light bars. Thus, the people who live or work in the building still can enjoy the natural light from the outside. In addition, disposing the LED elements on the first light transmissible substrate in the form of light bars can save the labor hour as compared with the processes of individually disposing the LED elements on the substrate. In addition, the LED light bars according to the embodiment of the invention may be aligned with the positioning portions to save the labor hour of the manufacturing processes when either the first or second light transmissible substrate has the positioning portions. In addition, the positioning portion is configured such that the LED elements can be orderly disposed on the first light transmissible substrate without being precisely aligned. So, the quality of the product can be significantly enhanced.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A light transmissible display apparatus, comprising:
a first light transmissible substrate; and
at least one light-emitting diode (LED) light bar disposed on the first light
transmissible substrate.

2. The light transmissible display apparatus according to claim 1, wherein the LED light bar has a plurality of packaged LED elements disposed on a circuit board by way of surface mount technology (SMT) or dual in-line package (DIP).

3. The light transmissible display apparatus according to claim 1, wherein the LED light bar has a plurality of LED dies and a circuit board, and the LED dies are disposed on the circuit board by way of wire bonding or flip chip bonding.

4. The light transmissible display apparatus according to claim 2 or 3, wherein the material of the circuit board comprises resin, metal core, glass, or ceramics.

5. The light transmissible display apparatus according to claim 1, wherein the first light transmissible substrate has at least one positioning portion aligned with the LED light bar.

6. The light transmissible display apparatus according to claim 1, further comprising:
an adhesive layer for adhering the LED light bar to the first light transmissible
substrate.

7. The light transmissible display apparatus according to claim 1, further comprising:
a molding compound covering the LED light bar.

8. The light transmissible display apparatus according to claim 1, further comprising:
a second light transmissible substrate disposed opposite the first light
transmissible substrate, wherein the LED light bar is interposed between the first light transmissible substrate and the second light transmissible substrate.

9. The light transmissible display apparatus according to claim 8, wherein the second light transmissible substrate has at least one positioning portion aligned with the LED light bar.

10. The light transmissible display apparatus according to claim 8, wherein each of the first light transmissible substrate and the second light transmissible substrate is a glass substrate.

11. The light transmissible display apparatus according to claim 8, further comprising:
an adhesive layer disposed between the first light transmissible substrate and the
second light transmissible substrate.

12. The light transmissible display apparatus according to claim 1, wherein when a plurality of the LED light bars is provided, the LED light bars are arranged in an array.

13. The light transmissible display apparatus according to claim 1, further comprising:
at least one thermoconductive element, disposed on the LED light bar.

14. The light transmissible display apparatus according to claim 1, further comprising:
at least one thermoconductive element, disposed on one side of the first light
transmissible substrate opposite the LED light bar.

15. The light transmissible display apparatus according to claim 1, wherein light emitted from the LED light bar transmits the first light transmissible substrate and emits out.
